# EUROPEAN PATENT SPECIFICATION

(11) **EP 2 128 906 B1**
(45) Date of publication and mention of the grant of the patent: **30.11.2016**
(21) Application number: 08712014.3
(22) Date of filing: 26.02.2008
(51) Int. Cl.: F21K 99/00, H01L 33/64, H01L 33/50

(54) **LIGHT-EMITTING DEVICE**
LICHTEMITTIERENDE EINRICHTUNG
DISPOSITIF ÉMETTANT DE LA LUMIÈRE

(30) Priority: 27.02.2007 JP 2007046856
(43) Date of publication of application: 02.12.2009
(73) Proprietor: Kyocera Corporation, Kyoto-shi Kyoto 612-8501 (JP)
(72) Inventor: MIYAKE, Toru, Higashiomi-shi Shiga 529-1595 (JP)
(74) Representative: Viering, Jentschura & Partner mbB Patent- und Rechtsanwälte
(86) International application number: PCT/JP2008/053330
(87) International publication number: WO 2008/105428

(56) References cited:
- WO-A1-2006/101257
- WO-A1-2007/040627
- WO-A2-2007/044472
- JP-A- 2004 140 185
- JP-A- 2005 158 957
- JP-A- 2006 108 640
- JP-A- 2006 179 520
- US-A1- 2007 007 542
- 'Thermal Conductivity of some common Materials and Gases', [Online] 18 March 2015, XP055185305 Retrieved from the Internet: <URL:https://web.archive.org/web/2015031804 3824/http://www.engineeringtoolbox.com/ther mal-conductivity-d_429.html> [retrieved on 2015-04-23]

## Description

### Technical Field

The present invention relates to a light-emitting device as described in the preamble of claim 1 used, for example, in a field of illumination.

### Background Art

A light emitting device of the aforementioned type is described in JP-A 2006-179520.

Recently, light-emitting devices equipped with light-emitting elements such as light-emitting diodes have been developed. Especially, improvement in light-emitting property of a light-emitting device is demanded in the field of illumination, for example. A light-emitting device is provided with a light-emitting member arranged on the light-emitting element or above the light-emitting element. The light-emitting member contains a fluorescent material which is excited by the light emitted from the light-emitting element, as disclosed, for example, in the Japanese Unexamined Patent Publication JP-A 2000-77723.

WO 2006/101257 A1 discloses a light emitting module having above an LED a phosphor layer and an oxide layer.

JP-A 2004-140185 discloses a light emitting device above which a phosphor layer and a light reflecting thin layer are provided.

The earlier filed application WO 2007/040627 A1 discloses a light emitter with a light source and above it a converter and a thermally conductive region.

The earlier filed application WO 2007/044472 A2 discloses an LED that is in contact with a light transmissive heat sink.

### Disclosure of the Invention

One of the methods of enhancing light-emitting property of a light-emitting device is to reduce deterioration of the light-emitting member caused by heat. Light-emitting property of a light-emitting member may be deteriorated due to heat. An object of the invention is to improve light-emitting property of a light-emitting device by accelerating heat dissipation from a light-emitting member to reduce deterioration thereof.

The present invention provides a light-emitting device according to claim 1. Further advantageous embodiments of the present invention are disclosed in the dependent claims.

According to the invention, the light-emitting property of the light-emitting member is improved by reducing heat deterioration of the light-emitting member. Therefore, the light-emitting property of the light-emitting device is improved.

### Brief Description of the Drawings

Other and further objects, features, and advantages of the invention will be more explicit from the following detailed description taken with reference to the drawings wherein:
Fig. 1 shows an illuminating apparatus 100 according to an embodiment which, as such, is not part of the invention;
Fig. 2 shows a constitution of the illuminating apparatus 100;
Fig. 3 shows a light-emitting device 1 shown in Fig. 1;
Fig. 4 is an enlarged schematic view of a light-emitting member 13 and a heat-dissipating layer 14;
Fig. 5 shows an example of heat-dissipating structures in the light-emitting device 1;
Fig. 6 shows another example of heat-dissipating structures in the light-emitting device 1;
Fig. 7 shows still another example of heat-dissipating structures in the light-emitting device 1;
Fig. 8 shows a manufacturing method of the light-emitting device 1;
Fig. 9 shows a manufacturing method of a composite member composed of the light-emitting member 13 and the heat-dissipating layer 14;
Figs. 10A to 10D show steps A in Fig. 9;
Fig. 11 shows an illuminating apparatus 100 according to another embodiment which, as such, is not part of the invention;
Fig. 12 shows a light-emitting device 1 shown in Fig. 11;
Fig. 13 is an enlarged schematic view of a light-emitting member 13 and a heat-dissipating layer 14;
Fig. 14 shows an example of heat-dissipating structures in the light-emitting device 1;
Fig. 15 shows another example of heat-dissipating structures in the light-emitting device 1;
Fig. 16 shows still another example of heat-dissipating structures in the light-emitting device 1;
Fig. 17 shows a light-emitting device 1 according to an embodiment of the invention;
Fig. 18 shows a light-emitting device 1 according to still another embodiment which, as such, is not part of the invention; and
Fig. 19 shows a light-emitting device 1 according to still another embodiment which, as such, is not part of the invention.

### Best Mode for Carrying Out the Invention

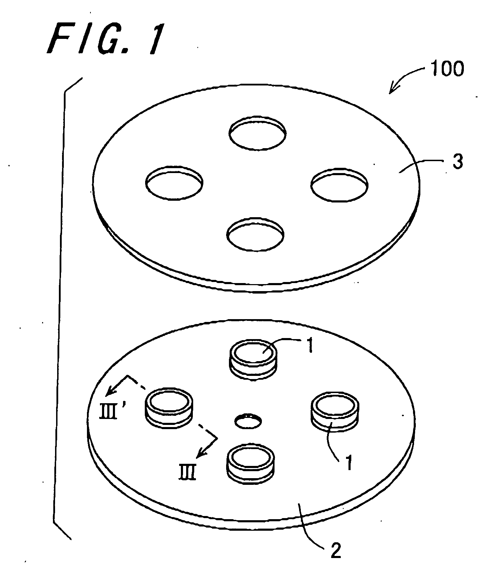

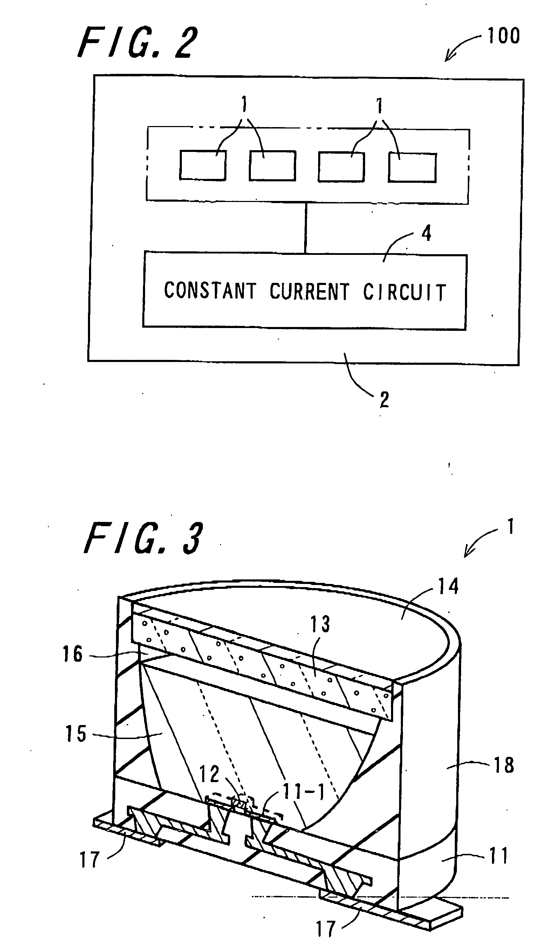

Hereafter, an embodiment which, as such, is not part of the invention will be described with reference to the drawings. An illuminating apparatus 100 according to this embodiment will be described with reference to Figs. 1 and 2. As shown in Fig. 1, the illuminating apparatus 100 comprises a plurality of light-emitting devices 1, a base plate 2 and a cover 3. The plurality of light-emitting devices 1 is mounted on the base plate 2. As shown in Fig. 2, the illuminating apparatus 100 further comprises a constant current circuit 4 arranged on the base plate 2. The constant current circuit 4 is electrically connected to the plurality of light-emitting devices 1.

As shown in Fig. 3, the light-emitting device 1 comprises a substrate 11, a light-emitting element 12 and a light-emitting member 13. The light-emitting device 1 further comprises a heat-dissipating layer 14, a sealing layer 15 and a heat-insulating layer 16. In Fig. 3, a part of the light-emitting device 1 is not illustrated. In Fig. 3, a cross-section at line III-III' in Fig. 1 is depicted with hatched lines.

The substrate 11 is made of a insulating material. An example of the insulating material is ceramics. The substrate 11 has conducting patterns 11-1.

The light-emitting element 12 is mounted on the substrate 11 and connected to the conducting patterns 11-1. The light-emitting element 12 is mounted using flip-chip bonding. In this embodiment, the light-emitting element 12 is a light-emitting diode (LED) composed of semiconductor materials, and has a plurality of layers. An active layer is included in the plurality of layers. The light-emitting element 12 is a light source that emits primary light with use of driving electric power. The primary light is within a blue rage or an ultraviolet range, or partly overlaps with these ranges.

In this embodiment, the light-emitting member 13 is arranged on or above the light-emitting element 12. In the light-emitting device 1 shown in Fig. 3, the light-emitting member 13 is arranged above the light-emitting element 12. The light-emitting member 13 has a sheet-like shape. The light-emitting member 13 emits secondary light in response to primary light. Examples of the secondary light are red light, green light and blue-light when the primary light is ultraviolet light. The light-emitting device 1 emits white light by mixing the red light, the green light and the blue-light. Another example of the secondary light is yellow light when the primary light is blue light. The light-emitting device 1 may emit white light by mixing the blue-light and the yellow light. The secondary light has a wavelength spectrum that is different from a wavelength spectrum of the primary light. The wavelength of the secondary light is longer than the wavelength of the secondary light. The light-emitting member 13 has a function of converting a wavelength of light.

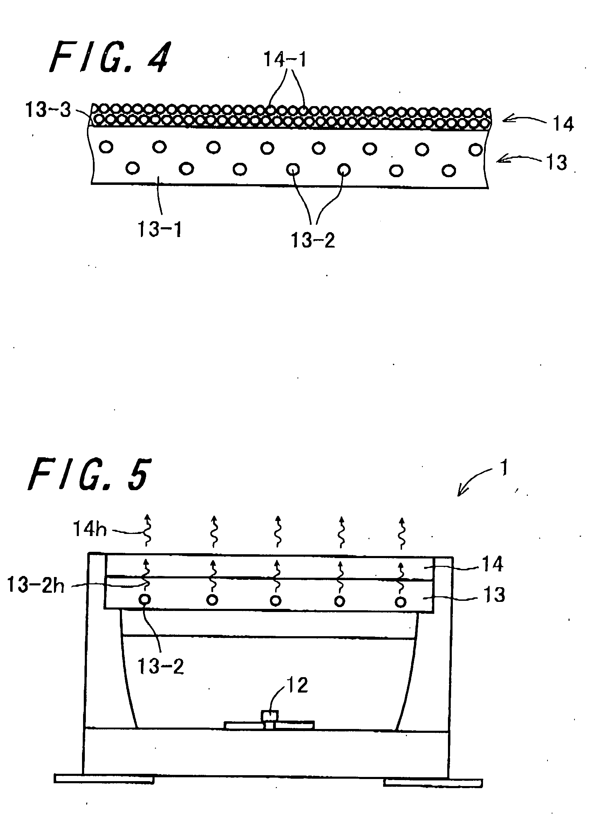

As shown in Fig. 4, the light-emitting member 13 has a matrix material 13-1 and a fluorescent material 13-2. The matrix material 13-1 has light-transmitting property. Here, "light-transmitting property" of the matrix material 13-1 means that at least part of the wavelength of the light emitted from the light emitting element 12 can be transmitted. At least part of the wavelength of the light emitted from the fluorescent material 13-2 is transmitted by the matrix material. An examples of the matrix material is glass or silicone resin. The fluorescent material 13-2 is embedded in the matrix material 13-1. The matrix material 13-1 is a base material that contains the fluorescent material 13-2. The fluorescent material 13-2 is excited by the primary light emitted from the light-emitting element 12.

As shown in Fig. 3, the heat-dissipating layer 14 is formed on a surface of the light-emitting member 13. Therefore, in the light-emitting device 1, an amount of heat that remains within the light-emitting member 13 is reduced. The heat-dissipating layer 14 has light-transmitting property. Here, "light-transmitting property" of the heat-dissipating layer 14 means that at least part of the wavelength of the light emitted from the light emitting member 13 can be transmitted. The heat-dissipating layer 14 is made of a material having higher thermal conductivity than that of the light-emitting member 13.

As shown in Fig. 4, the heat-dissipating layer 14 is made of metal oxide 14-1. The metal oxide 14-1 has higher thermal conductivity than that of the matrix material 13-1 of the light-emitting member 13. The metal oxide 14-1 is deposited on a surface of the light-emitting member 13. Therefore, in the light-emitting device 1, an amount of heat that is conducted from the light-emitting member 13 to the metal oxide 14-1 is increased. The metal oxide 14-1 is deposited on the matrix material 13-1 of the light-emitting member 13. The heat-dissipating layer 14 is a thin layer that is formed on the light-emitting member 13. In the light-emitting device 1, an amount of heat that remains within the matrix material 13-1 of the light-emitting member 13 is reduced. Because the light-emitting device 1 of this embodiment has the heat-dissipating layer 14, deterioration of the light-emitting member 13 is reduced.

The metal oxide 14-1 is oxidized zinc. Thus; the heat-dissipating layer 14 is composed of zinc oxide (ZnO). The heat-dissipating layer 14 is a light-transmitting electrically conductive film. Another example of the metal oxide 14-1 is oxidized indium and oxidized tin. Thus, the heat-dissipating layer 14 is made of an alloy of indium oxide and tin oxide (In₂O₃∼SnO₂). In other words, the heat-dissipating layer 14 is composed of indium tin oxide (ITO). Another example of the metal oxide 14-1 is oxidized titanium. Thus, the heat-dissipating layer 14 is composed of titanium dioxide (TiO₂).

The heat-dissipating layer 14 is formed on a top surface 13-3 of the light-emitting member 13. Herein, a top surface 13-3 means a surface that is on a farther side from the light-emitting element 12, among the surfaces of the light-emitting member 13. The top surface 13-3 is an outer surface of the light-emitting member 13.

The sealing layer 15 is attached to a surface of the light-emitting element 12. The sealing layer 15 has light-transmitting property. Here, "light-transmitting property" of the sealing layer 15 means that at least part of the wavelength of the light emitted from the light emitting element 12 can be transmitted. The sealing layer 15 is made of silicone resin. The heat-insulating layer 16 is arranged between the light emitting element 12 and the light-emitting member 13. Therefore, an amount of heat that is emitted from the light-emitting element 12 and conducted to the light emitting member 13 is reduced. The heat-insulating layer 16 is an air gap. The heat-insulating layer 16 is arranged between the light emitting member 13 and the sealing layer 15. Here, "heat-insulating" with respect to the layer 16 means reducing an amount of heat that is emitted from the light-emitting element 12 and conducted to the light emitting member 13. The light-emitting device 1 has a plurality of external terminals 17. The external terminals 17 are electrically connected to the conducting patterns 11-1. Driving electric power is supplied to the external terminals 17. The light-emitting device 1 further comprises a frame member 18 arranged on the substrate 11. The frame member 18 surrounds the light-emitting element 12. The light-emitting member 13 is fixed to the frame member 18.

Now, heat-dissipating structures in the light-emitting device 1 will be described with reference to Figs. 5 to 7. As shown in Fig. 5, a first example of the heat-dissipating structure is a structure in which heat is dissipated from a top end of the light-emitting device 1. When the fluorescent material 13-2 is excited, heat 13-2h is emitted from the fluorescent material 13-2. The heat 13-2h is conducted to the heat-dissipating layer 14 and released from a top surface of the heat-dissipating layer 14. The heat released from the top surface of the heat-dissipating layer 14 is denoted by reference numeral 14h. Deterioration of the light-emitting member 13 due to the heat 13-2h is reduced.

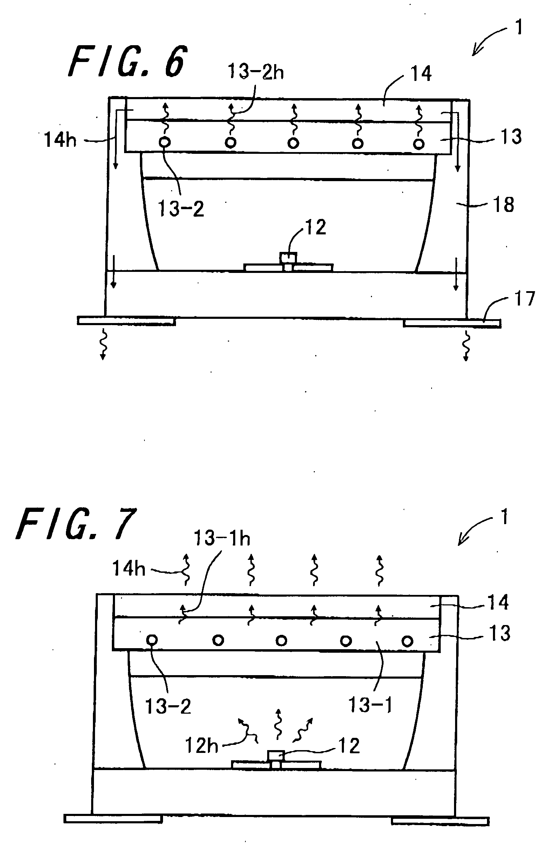

As shown in Fig. 6, a second example of the heat-dissipating structure is a structure in which heat is dissipated from a bottom end of the light-emitting device 1. The heat 13-2h emitted from the fluorescent material 13-2 is conducted to the heat-dissipating layer 14. The heat-dissipating layer 14 is in contact with the frame member 18. Therefore, the heat 13-2h is conducted from the heat-dissipating layer 14 to the frame member 18. The heat conducted to the frame member 18 is denoted by reference numeral 14h. The heat 14h is released from the bottom end of the light-emitting device 1 by way of the external terminals 17, for example. Deterioration of the light-emitting member 13 due to the heat 13-2h is reduced. The heat 14h may be released into an atmosphere from the frame member 18.

As shown in Fig. 7, a third example of the heat-dissipating structure is a structure associated with the heat that is generated by the light-emitting element 12. The heat generated by the light-emitting element 12 is denoted by reference numeral 12h. In some cases, the heat 12h is conducted to the light-emitting member 13. The heat 13-1h conducted to the matrix material 13-1 of the light-emitting member 13 is further conducted to the heat-dissipating layer 14. The heat 14h conducted to the heat-dissipating layer 14 is released from the top surface of the heat-dissipating layer 14. The heat released from the top surface of the heat-dissipating layer 14 is denoted by reference numeral 14h. Deterioration of the light-emitting member 13 due to the heat 13-1h is reduced.

As shown in Fig. 3, the heat-dissipating layer 14 is formed on the entire top surface of the light-emitting member 13. Due to this configuration, in the light-emitting device 1 is reduced unevenness of heat dissipation at the top surface of light-emitting member. 13. Therefore, unevenness of light emission of the light-emitting device 1 is reduced.

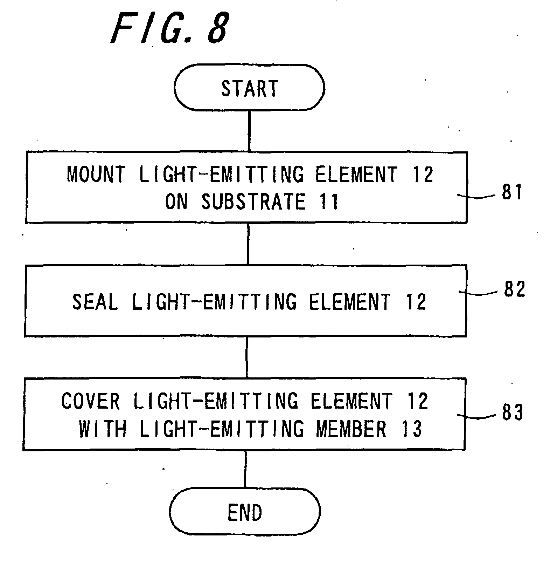

A method of manufacturing the light-emitting device 1 will be described with reference to Fig. 8. At step 81, the light-emitting element 12 is mounted on the substrate 11. At step 82, the light-emitting element 12 is sealed with the layer 15. At step 83, the light-emitting element 12 is covered with the light-emitting member 13. The heat-dissipating layer 14 has been formed on the surface of the light-emitting member 13.

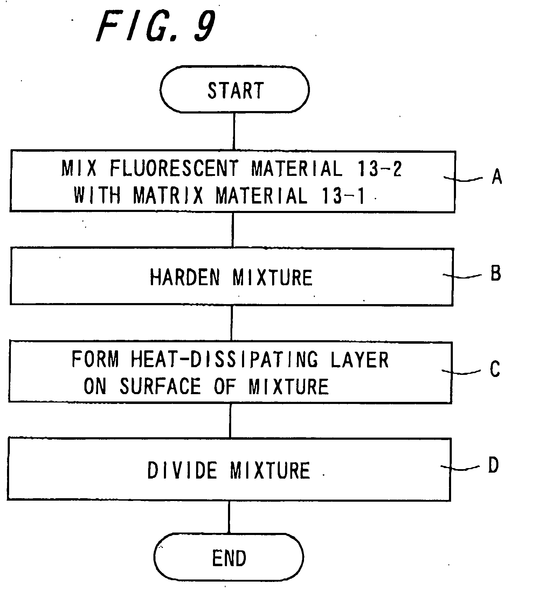

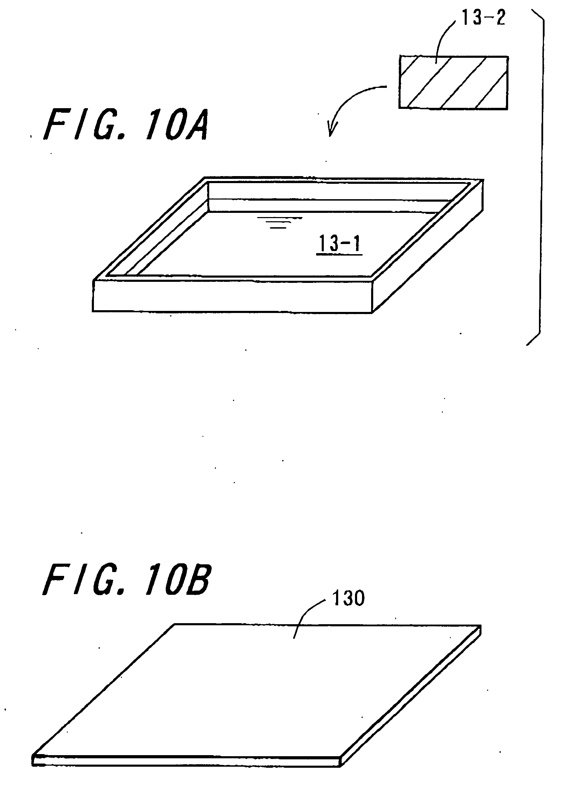

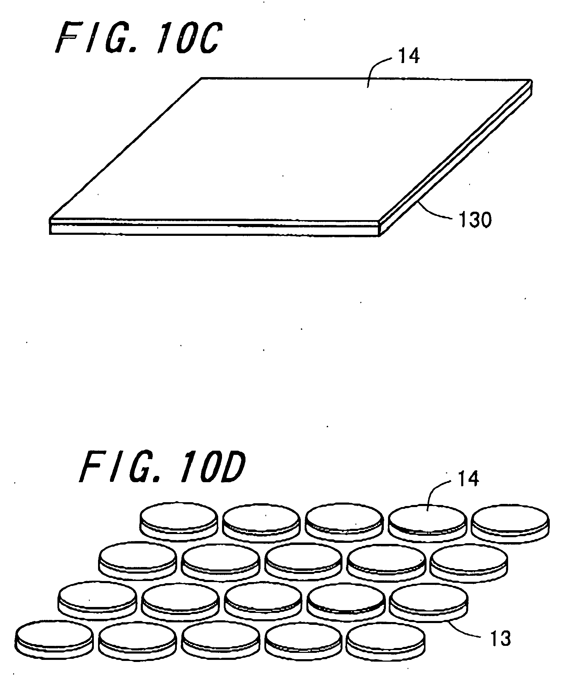

A method of manufacturing a composite member composed of the light-emitting member 13 and the heat-dissipating layer 14 will be described with reference to Fig. 9. At step A, as shown in Fig. 10, the fluorescent material 13-2 is mixed with the matrix material 13-1 having been fused. At step B, the mixture is hardened. As shown in Fig 10B, a sheet-shaped mixture 130 is obtained.

At step C, as shown in Fig. 10C, the heat-dissipating layer 14 is formed on a surface of the mixture 130. An example of the method of forming the heat-dissipating layer 14 is physical vapor-phase growth. An example of physical vapor-phase growth is sputtering or vapor deposition. For example, a heat-dissipating layer 14 composed of zinc oxide (ZnO) is formed by sputtering on the surface of the hardened mixture 130 composed of glass and the fluorescent material. A method of vapor deposition is selected from the group consisting of vacuum deposition, sputter deposition, laser deposition, pulsed laser deposition and reactive plasma deposition.

Another example of the method of forming the heat-dissipating layer 14 is a sol-gel process. For example, sol in which particles of zinc (Zn) are dispersed is applied on the surface of the hardened mixture 130 composed of glass and the fluorescent material. By drying the sol, a gel is obtained, which does not have fluidity any more. Firing of the gel produces a heat-dissipating layer 14 composed of zinc oxide (ZnO).

At step D, as shown in Fig. 10D, the mixture is divided, for example, by mechanical cutting. Thus, at step D, light-emitting members 13 each having the heat-dissipating layer 14 is obtained. That is, at step D, a composite member composed of the light-emitting member 13 and the heat-dissipating layer 14 is obtained.

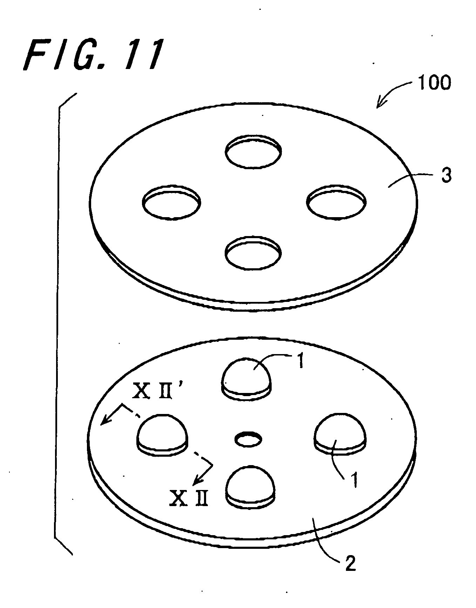

Hereafter, another embodiment which, as such, is not part of the invention will be described with reference to the drawings. As shown in Fig. 11, an illuminating apparatus 100 according to this embodiment comprises a plurality of light-emitting devices 1, a base plate 2 and a cover 3. The light-emitting device 1 has a domical shape.

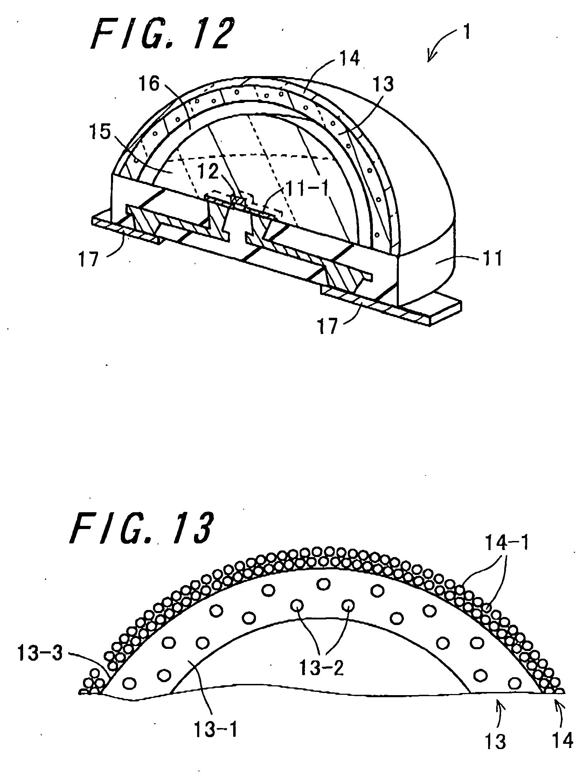

As shown in Fig. 12, the light-emitting device 1 comprises a substrate 11, a light-emitting element 12 and a light-emitting member 13. The light-emitting device 1 further comprises a heat-dissipating layer 14, a sealing layer 15 and a heat-insulating layer 16. In Fig. 12, part of the light-emitting device 1 is not illustrated. In Fig. 12, a cross-section at line XII-XII' in Fig. 11 is depicted with hatched lines.

In this embodiment, the shape of the light-emitting member 13 is different from that of the light-emitting device 1 shown in Fig. 3. In this embodiment, the light-emitting member 13 has a domical shape. The sealing layer 15 also has a domical shape in accordance with the shape of the light-emitting member 13.

The heat-dissipating layer 14 is formed on a surface of the light-emitting member 13. The heat-dissipating layer 14 also has a domical shape. As shown in Fig. 13, the heat-dissipating layer 14 is made of metal oxide 14-1. The metal oxide 14-1 is deposited on the surface of the light-emitting member 13. The metal oxide 14-1 is deposited on a matrix material 13-1 of the light-emitting member 13.

The heat-dissipating layer 14 is formed on a top surface 13-3 of the light-emitting member 13. Here, a top surface 13-3 means a surface that is on a farther side from the light-emitting element 12, among the surfaces of the light-emitting member 13. The top surface 13-3 is an outer surface of the light-emitting member 13.

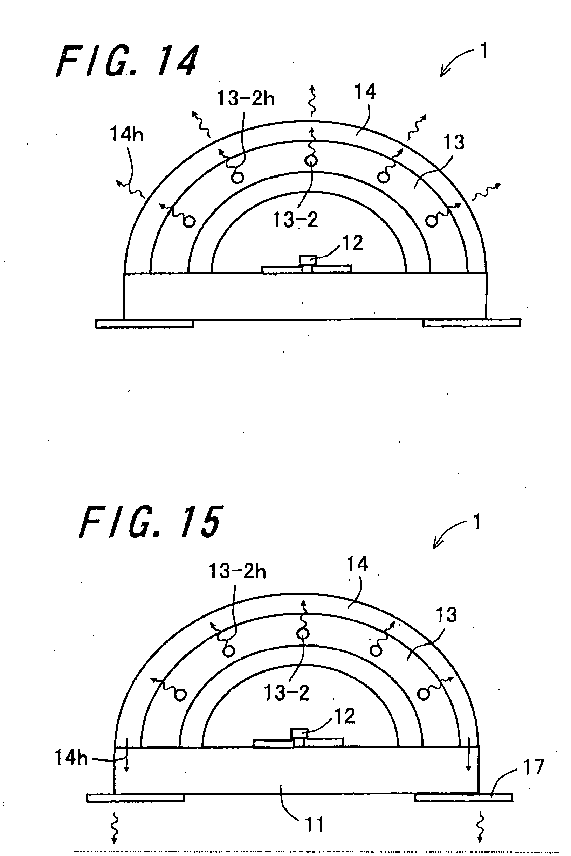

Now, heat-dissipating structures in the light-emitting device 1 will be described with reference to Figs. 14 to 16. As shown in Fig. 14, a first example of the heat-dissipating structure in this embodiment is a structure in which heat is dissipated from a top surface of the light-emitting device 1. Heat 13-2h emitted from the fluorescent material 13-2 is conducted to the heat-dissipating layer 14 and released from a top surface of the heat-dissipating layer 14. The heat released from the top surface of the heat-dissipating layer 14 is denoted by reference numeral 14h. Deterioration of the light-emitting member 13 due to the heat 13-2h is reduced.

As shown in Fig. 15, a second example of the heat-dissipating structure in this embodiment is a structure in which heat is dissipated from a bottom end of the light-emitting device 1. The heat 13-2h emitted from the fluorescent material 13-2 is conducted to the heat-dissipating layer 14. The heat 13-2h is conducted from the heat-dissipating layer 14 to the substrate 11. The heat conducted to the substrate 11 is denoted by reference numeral 14h. The heat 14h is released from the bottom end of the light-emitting device 1 by way of the external terminals 17, for example. Deterioration of the light-emitting member 13 due to the heat 13-2h is reduced.

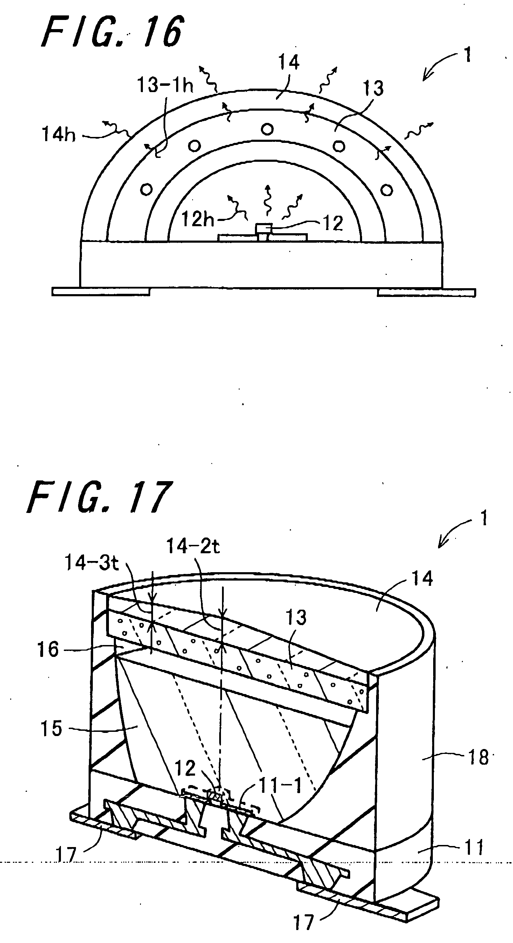

As shown in Fig. 16, a third example of the heat-dissipating structure in this embodiment is a structure associated with the heat that is generated by the light-emitting element 12. The heat generated by the light-emitting element 12 is denoted by reference numeral 12h. In some cases, the heat 12h is conducted to the light-emitting member 13. The heat 13-1h conducted to the matrix material 13-1 of the light-emitting member 13 is further conducted to the heat-dissipating layer 14. The heat 14h conducted to the heat-dissipating layer 14 is released from the top surface of the heat-dissipating layer 14. The heat released from the top surface of the heat-dissipating layer 14 is denoted by reference numeral 14h. Deterioration of the light-emitting member 13 due to the heat 13-1h is reduced.

An embodiment of the invention will be described with reference to Fig. 17. In this embodiment, the shape of the heat-dissipating layer 14 is different from that of the light-emitting device 1 shown in Fig. 3. In this embodiment, the heat-dissipating layer 14 has a thickest part thereof immediately above the light-emitting element 12. The light-emitting member 13 has a sheet-like shape. Heat energy tends to arise more in that part of the light-emitting member 13 which is located immediately above the light-emitting element 12, than in other parts of the light-emitting member 13. The thickness 14-2t of the heat-dissipating layer 14 immediately above the light-emitting element 12 is greater than the thickness 14-3t of other parts. Therefore, in the light-emitting device 1 of this embodiment, efficiency of dissipation of the heat generated by the light-emitting member 13 is enhanced.

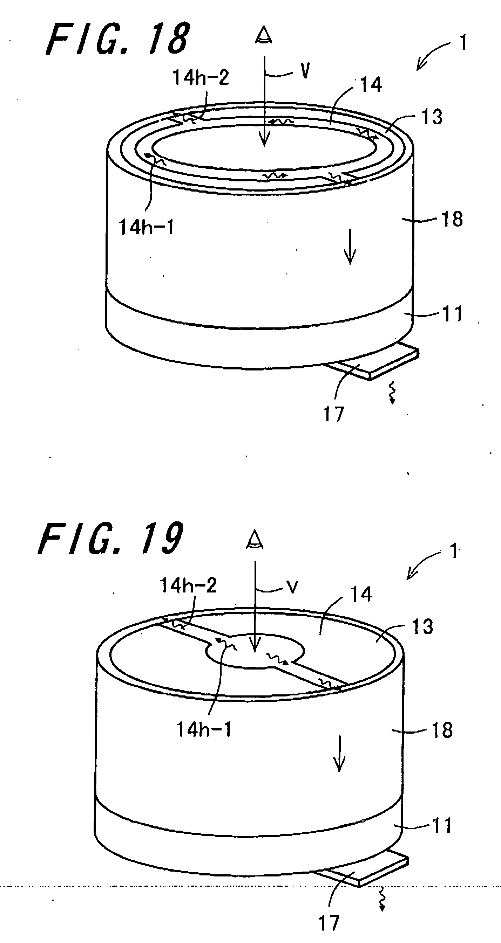

Another embodiment which, as such, is not part of the invention will be described with reference to Fig. 18. In this embodiment, the shape of the heat-dissipating layer 14 is different from that of the light-emitting device 1 shown in Fig. 3. In this embodiment, the heat-dissipating layer 14 is formed on a part of the surface of the light-emitting member 13. In a planar view, the light-emitting member 13 is partly out of the heat-dissipating layer 14 so as to be exposed. Here, a planar view means looking along the line of sight denoted by reference symbol V in Fig. 18. In the light-emitting device 1 of this embodiment, loss of light emitted from the light-emitting member 13 is reduced. The heat-dissipating layer 14 is partly in contact with the frame member 18.

Examples of the heat-dissipating structures in the light-emitting device 1 are denoted by reference numerals 14h-1 and 14h-2. The heat generated by the light-emitting member 13 is conducted along the heat-dissipating layer 14, as denoted by reference numeral 14h-1. The heat is conducted to the frame member 18, as denoted by reference numeral 14h-2. The heat is released from the bottom end of the light-emitting device 1 by the external terminals 17, for example.

Another embodiment which, as such, is not part of the invention will be described with reference to Fig. 19. In this embodiment, the shape of the heat-dissipating layer 14 is different from that of the light-emitting device 1 shown in Fig. 3. In this embodiment, the heat-dissipating layer 14 is formed on a part in a central area of the top surface of the light-emitting member 13. In a planar view, the light-emitting member 13 is partly out of the heat-dissipating layer 14 so as to be exposed. Here, a planar view means looking along the line of sight denoted by reference symbol V in Fig. 19. The heat-dissipating layer 14 is partly in contact with the frame member 18.

Heat energy tends to arise more in that part of the light-emitting member 13 which is located immediately above the light-emitting element 12, than in other parts of the light-emitting member 13. The heat generated in the part of the light-emitting member 13 immediately above the light-emitting element 12 is conducted, by way of the heat-dissipating layer 14, to the frame members 18 or the like. In Fig. 19, the heat conducted along the heat-dissipating layer 14 is denoted by reference numerals 14h-1 and 14h-2.

The invention may be embodied in other specific forms without departing from the essential characteristics thereof. The present embodiment of the invention is therefore to be considered in all respects as illustrative and not restrictive, the scope of the invention being indicated by the appended claims rather than by the foregoing description and all changes which come within the meaning and the range of equivalency of the claims are therefore intended to be embraced therein.

## Claims

1. A light-emitting device comprising:
a light-emitting diode (12) made of a semiconductor material;
a light-emitting member (13) containing a fluorescent material, and arranged on or above the light-emitting diode (12); and
a heat-dissipating layer (14) made of a material having higher thermal conductivity than that of the light-emitting member (13), and formed on a surface of the light-emitting member (13),
wherein the heat-dissipating layer is composed of metal oxide deposited on the surface of the light-emitting member (13) and wherein the metal oxide is oxidized zinc or oxidized titanium
**characterized in that**
the heat-dissipating layer (14) has a thickest part immediately above the light-emitting diode (12).

2. The light-emitting device of claim 1, wherein the fluorescent material is embedded in a matrix material.

3. The light-emitting device of claim 2, wherein the heat-dissipating layer (14) is deposited on the matrix material.

4. The light-emitting device of claim 3, wherein the matrix material is glass.

5. The light-emitting device of claim 3, wherein the matrix material is resin.

6. The light-emitting device of claim 1, wherein the heat-dissipating layer (14) is formed on a surface that is on a farther side from the light-emitting diode (12), among the surfaces of the light-emitting member (13).

7. The light-emitting device of claim 1, further comprising a heat-insulating layer arranged between the light-emitting diode (12) and the light-emitting member (13).

## Patentansprüche

1. Eine lichtemittierende Vorrichtung, aufweisend:
eine lichtemittierende Diode (12), die aus einem Halbleitermaterial hergestellt ist,
ein lichtemittierendes Element (13), das ein Leuchtmaterial enthält und auf oder über der lichtemittierenden Diode (12) angeordnet ist, und
eine Wärmeabführschicht (14), die aus einem Material hergestellt ist, das eine höhere Wärmeleitfähigkeit als diejenige des lichtemittierenden Elements (13) hat, und die auf einer Fläche des lichtemittierenden Elements (13) ausgebildet ist,
wobei die Wärmeabführschicht aus Metalloxid gebildet ist, das auf der Oberfläche des lichtemittierenden Elements (13) aufgebracht ist, und wobei das Metalloxid oxidiertes Zink oder oxidiertes Titan ist,
**dadurch gekennzeichnet, dass**
die Wärmeabführschicht (14) einen dicksten Teil direkt über der lichtemittierenden Diode (12) hat.

2. Die lichtemittierende Vorrichtung gemäß Anspruch 1, wobei das Leuchtmaterial in ein Matrixmaterial eingebettet ist.

3. Die lichtemittierende Vorrichtung gemäß Anspruch 2, wobei die Wärmeabführschicht (14) auf dem Matrixmaterial aufgebracht ist.

4. Die lichtemittierende Vorrichtung gemäß Anspruch 3, wobei das Matrixmaterial Glas ist.

5. Die lichtemittierende Vorrichtung gemäß Anspruch 3, wobei das Matrixmaterial Harz ist.

6. Die lichtemittierende Vorrichtung gemäß Anspruch 1, wobei die Wärmeabführschicht (14) auf einer Fläche ausgebildet ist, die sich von den Flächen des lichtemittierenden Elements (13) auf einer von der lichtemittierenden Diode (12) entfernten Seite befindet.

7. Die lichtemittierende Vorrichtung gemäß Anspruch 1, ferner aufweisend eine Wärmeisolierungsschicht, die zwischen der lichtemittierenden Diode (12) und dem lichtemittierenden Element (13) angeordnet ist.

## Revendications

1. Un dispositif à émission de lumière, comportant :
une diode à émission de lumière (12) fabriquée en un matériau semi-conducteur,
un élément à émission de lumière (13) qui contient un matériau fluorescent et qui est disposé sur ou au-dessus de la diode à émission de lumière (12), et
une couche dissipant la chaleur (14) fabriquée en un matériau présentant une conductibilité thermique qui est supérieure à celle de l'élément à émission de lumière (13) est qui est formée sur une surface de l'élément à émission de lumière (13),
dans lequel la couche dissipant la chaleur est composée d'un oxyde métallique déposé sur la surface de l'élément à émission de lumière (13), et dans lequel l'oxyde métallique est du zinc oxydé ou du titane oxydé,
**caractérisé en ce que**
la couche dissipant la chaleur (14) a une partie la plus épaisse juste au-dessus de la diode à émission de lumière (12).

2. Le dispositif à émission de lumière selon la revendication 1, dans lequel le matériau fluorescent est encastré dans un matériau de matrice.

3. Le dispositif à émission de lumière selon la revendication 2, dans lequel la couche dissipant la chaleur (14) est déposée sur le matériau de matrice.

4. Le dispositif à émission de lumière selon la revendication 3, dans lequel le matériau de matrice est le verre.

5. Le dispositif à émission de lumière selon la revendication 3, dans lequel le matériau de matrice est la résine.

6. Le dispositif à émission de lumière selon la revendication 1, dans lequel la couche dissipant la chaleur (14) est formée sur une surface qui est sur un côté éloigné de la diode à émission de lumière (12) parmi les surfaces de l'élément à émission de lumière (13).

7. Le dispositif à émission de lumière selon la revendication 1, comportant en outre une couche d'isolation thermique disposée entre la diode à émission de lumière (12) et l'élément à émission de lumière (13).
